# EUROPEAN PATENT APPLICATION

(11) **EP 4 708 358 A1**
(43) Date of publication of application: **11.03.2026**
(21) Application number: 24813908.1
(22) Date of filing: 09.04.2024
(51) Int. Cl.: H01L 23/367

(54) **CHIP AND MANUFACTURING METHOD THEREFOR, AND ELECTRONIC DEVICE**

(30) Priority: 26.05.2023 CN 202310610896
(71) Applicant: Huawei Technologies Co., Ltd., Shenzhen, Guangdong 518129 (CN)
(72) Inventor: REN, Changyou, Shenzhen, Guangdong 518129 (CN); HAN, Zuoyan, Shenzhen, Guangdong 518129 (CN); LI, Xiaoyue, Shenzhen, Guangdong 518129 (CN)
(74) Representative: Goddar, Heinz J.
(86) International application number: PCT/CN2024/086818
(87) International publication number: WO 2024/244702

(57) **Abstract**

This application provides a chip, a manufacturing method thereof, and an electronic device. When a chemical gold-plated layer is manufactured on a nickel-containing adhesive layer by using a chemical gold plating method, because chemical gold plating is not affected by an electric field or a magnetic field, gold can easily enter a through hole without being affected by an incident angle. Gold is deposited on a surface of the adhesive layer through a replacement reaction between nickel and gold, and gold entering the through hole can increase a thickness of the chemical gold-plated layer inside the through hole to reduce a difference between thicknesses of the chemical gold-plated layer inside and outside the through hole, so that a difference between thicknesses of the conductive plating layer inside and outside the through hole is reduced, a subconformal phenomenon is avoided, uniformity of the conductive plating layer inside and outside the through hole is improved, and performance of the conductive plating layer and even the chip is improved. In addition, because the adhesive layer is a nickel-containing film layer, gold can be deposited on the surface of the adhesive layer, and gold is not deposited at another position without the adhesive layer. In this way, amount of gold used is reduced, and manufacturing costs of the chip are reduced.

## Description

### CROSS-REFERENCE TO RELATED APPLICATIONS

This application claims priority to Chinese Patent Application No. 202310610896.4, filed with the China National Intellectual Property Administration on May 26, 2023 and entitled "CHIP, MANUFACTURING METHOD THEREOF, AND ELECTRONIC DEVICE", which is incorporated herein by reference in its entirety.

### TECHNICAL FIELD

This application relates to the field of semiconductor technologies, and in particular, to a chip, a manufacturing method thereof, and an electronic device.

### BACKGROUND

A chip includes a substrate and a semiconductor device disposed on the substrate. The semiconductor device is, for example, a transistor or a capacitor. One side of surface on which the semiconductor device is disposed may be referred to as a front surface of the substrate, and the other side of surface may be referred to as a back surface of the substrate. When a through hole is provided in the substrate, the through hole may be covered by a power supply end or a ground end of the semiconductor device. Therefore, when a conductive plating layer is manufactured on the back surface of the substrate, the conductive plating layer covers not only the back surface, but also a side wall of the through hole and a surface that is of the power supply end or the ground end and that is exposed from the through hole. In this way, heat generated when the semiconductor device works can be conducted out from the back surface, so that a heat dissipation capability of the chip is improved. In addition, structural complexity of the front surface of the substrate can be reduced, and the power supply end or the ground end of the semiconductor device can be simplified by using space on the back surface of the substrate.

However, in the conventional technology, a thickness of a conductive plating layer manufactured on a back surface of a substrate differs greatly inside and outside a through hole, and a subconformal phenomenon effect is prone to occur. In this case, performance of the conductive plating layer inside and outside the through hole is uneven, and consequently, performance of the conductive plating layer deteriorates, and performance of the chip is affected.

### SUMMARY

This application provides a chip, a manufacturing method thereof, and an electronic device, to reduce a difference between thicknesses of a conductive plating layer inside and outside a through hole, and improve performance of the conductive plating layer and even the chip.

According to a first aspect, an embodiment of this application provides a chip. The chip may include a substrate and a conductive structure. The substrate has a first surface and a second surface that are disposed opposite to each other, and a through hole that penetrates the first surface and the second surface. There may be one, two, three, or more through holes, with no quantity limitation herein, since how many through holes are provided is based on an actual requirement. The conductive structure may be disposed on the first surface. One, two, or more conductive structures may be disposed. Functions of the conductive structures include but are not limited to transmitting a power signal, a ground signal, or another signal. The functions of the conductive structures may be the same, partially the same, or all different function, and may be specifically set based on an actual requirement. Regardless of a quantity of disposed conductive structures and setting of a function of each conductive structure, the requirement is met provided that one conductive structure covers the through hole. In addition, a quantity of through holes covered by the conductive structure is not limited herein either.

The chip may further include a conductive plating layer. The conductive plating layer may be formed on the second surface, a side wall of the through hole, and a surface that is of the conductive structure and that is exposed from the through hole. A part of the second surface other than the through hole may be referred to as an area other than the through hole. The side wall of the through hole may be referred to as a hole wall for short. The surface that is of the conductive structure and that is exposed from the through hole may be considered as a hole bottom. In this way, the conductive plating layer is disposed on the area other than the through hole, the hole wall, and the hole bottom, and the conductive plating layer is connected to the conductive structure, so that heat in the conductive structure may be conducted out to the second surface through the conductive plating layer and dissipated through the second surface, and a signal transmitted by the conductive structure may be transmitted to the conductive plating layer.

The conductive plating layer may include an adhesive layer that is formed on the area other than the through hole, the hole wall, and the hole bottom, a chemical gold-plated layer formed on the adhesive layer, and a gold electroplated layer formed on the chemical gold-plated layer, so that the adhesive layer, the chemical gold-plated layer, and the gold electroplated layer are sequentially stacked in a direction from the first surface to the second surface. In this way, when the chemical gold-plated layer (which may also be referred to as a seed layer) is manufactured on the nickel-containing adhesive layer by using a chemical gold plating method, because chemical plating is not affected by an electric field or a magnetic field, there is no problem related to an incident angle of a particle, and gold can easily enter the through hole without being affected by the incident angle. Gold is deposited on a surface of the adhesive layer through a replacement reaction between nickel and gold, and gold entering the through hole can increase a thickness of the seed layer inside the through hole, to reduce a difference between thicknesses of the seed layer inside and outside the through hole, so that a difference between thicknesses of the gold electroplated layer inside and outside the through hole is reduced. In this way, a difference between thicknesses of the conductive plating layer inside and outside the through hole is reduced, a subconformal phenomenon is avoided, uniformity of the conductive plating layer inside and outside the through hole is improved, and performance of the conductive plating layer and even the chip is improved. In addition, because the adhesive layer is a nickel-containing film layer, the seed layer may be manufactured on the surface of the adhesive layer, and gold is not deposited at another position without the adhesive layer. This resolves a problem of gold waste caused by deposition of most gold on an inner wall of a device cavity in a physical vapor deposition (Physical Vapor Deposition, PVD) method, and reduces amount of gold used, so that manufacturing costs of the chip are reduced.

In some embodiments, for the chemical gold-plated layer, if a ratio of a first thickness at any position inside the through hole to a second thickness at any position on the second surface is set to be greater than or equal to 0.5, it indicates that a difference between thicknesses of the seed layer inside and outside the through hole is small, and resistance of the seed layer inside the through hole is effectively reduced. Therefore, when the gold electroplated layer is manufactured on the seed layer by using a gold electroplating method, the gold electroplated layer inside the through hole may be thick to further reduce the difference between thicknesses inside and outside the through hole during gold electroplating, further improve thickness uniformity of the conductive plating layer, and further reduce gold electroplating time. This can not only reduce amount of gold used, but also improve manufacturing efficiency of the conductive plating layer and even the chip.

For example, any position inside the through hole mentioned above may include a position from one third to two-thirds of a depth of the through hole, for example, include a position at a half depth of the through hole. Thicknesses of the chemical gold-plated layer at these positions are close to an average value of thicknesses of the chemical gold-plated layer at various positions inside the through hole. Selecting the thicknesses of the chemical gold-plated layer at these positions as a first thickness can easily achieve that the ratio of the first thickness to the second thickness is greater than or equal to 0.5. This helps reduce the difference between thicknesses of the gold electroplated layer inside and outside the through hole, and reduce gold electroplating time.

In addition, setting the second thickness to be greater than or equal to 300 nm helps implement a specific thickness of the chemical gold-plated layer inside the through hole, and avoids an excessively large resistance caused by an excessively thin chemical gold-plated layer inside the through hole. This helps reduce the difference between thicknesses of the gold electroplated layer inside and outside the through hole, reduce the difference between thicknesses of the conductive plating layer inside and outside the through hole, and further reduce the difference between thicknesses of the conductive plating layer inside and outside the through hole especially when the ratio of the first thickness to the second thickness is greater than or equal to 0.5. In addition, when the second thickness is greater than or equal to 300 nm, internal stress of the chemical gold-plated layer can be reduced, and warpage of the chemical gold-plated layer can be avoided. This helps reduce the difference between thicknesses of the conductive plating layer inside and outside the through hole, and improve performance of the conductive plating layer and even the chip.

In some embodiments, for the adhesive layer, an atomic percent of a nickel element may be set to be greater than or equal to 80%, and an atomic percent of another corresponding element is not greater than 20%. In this way, the adhesive layer may have a relatively large quantity of nickel elements. During chemical gold plating, the surface of the nickel-containing film layer may be directly plated without using any catalyst, and content of nickel in the adhesive layer has specific impact on a gold plating effect. Higher nickel content indicates easier gold plating, and lower nickel content indicates lower easiness of gold plating. Therefore, higher nickel content in the adhesive layer can promote and accelerate gold deposition, so that gold can be easily deposited on the surface of the adhesive layer, and manufacturing efficiency of the chemical gold-plated layer is improved.

In addition, the adhesive layer may be made of at least one of elementary nickel and a nickel-containing inorganic compound, and the adhesive layer may be of a single-layer structure or a multi-layer structure. When the adhesive layer is of a multi-layer structure, materials of layers may be the same or different, and may be specifically set based on an actual requirement. The nickel-containing inorganic compound may be selected from at least one of a nickel-vanadium alloy, a nickel phosphide, a nickel nitride, a nickel boride, a nickel-tungsten alloy, a nickel-aluminum alloy, a nickel-titanium alloy, a nickel-thallium alloy, a nickel-chromium alloy, and the like, so that a material selection range is wide, and requirements in various application scenarios are met.

In addition, when the adhesive layer is manufactured, the adhesive layer may be manufactured by using a PVD method, and a thickness of the adhesive layer may be controlled to be from 0.1 µm to 0.5 µm. In this way, a gold plating effect during chemical gold plating can be prevented from being affected when the adhesive layer is excessively thin, so that the chemical gold-plated layer is easily formed on the adhesive layer, and unnecessary waste caused when the adhesive layer is excessively thick can be avoided. This helps reduce manufacturing costs on the basis of reducing the difference between thicknesses of the chemical gold-plated layer inside and outside the through hole.

In some embodiments, the substrate may be made of a compound material of group III and group V elements. For example, the compound material of group III and group V elements includes but is not limited to GaP, GaAs, AlAs, AlP, AlSb, InP, InSb, InAs, GaInAs, GaInP, GaAlP, and GaAlAs. The conductive structure may be made of a conductive material. For example, the conductive material includes but is not limited to a conductive metal, a conductive metal oxide, a conductive metal alloy, and a conductive organic compound.

According to a second aspect, an embodiment of this application provides a chip manufacturing method, which may include: forming a conductive structure on a substrate, where the substrate has a first surface and a second surface that are disposed opposite to each other, and a through hole that penetrates the first surface and the second surface, and the conductive structure is located on the first surface and covers the through hole; forming an adhesive layer on the second surface, a side wall of the through hole, and a surface that is of the conductive structure and that is exposed from the through hole, where the adhesive layer includes a nickel element; forming a chemical gold-plated layer on the adhesive layer; and forming a gold electroplated layer on the chemical gold-plated layer.

In this way, when the chemical gold-plated layer (which may also be referred to as a seed layer) is manufactured on the nickel-containing adhesive layer by using a chemical gold plating method, because chemical plating is not affected by an electric field or a magnetic field, there is no problem related to an incident angle of a particle, and gold can easily enter the through hole without being affected by the incident angle. Gold is deposited on a surface of the adhesive layer through a replacement reaction between nickel and gold, and gold entering the through hole can increase a thickness of the seed layer inside the through hole, to reduce a difference between thicknesses of the seed layer inside and outside the through hole, so that a difference between thicknesses of the gold electroplated layer inside and outside the through hole is reduced. In this way, a difference between thicknesses of the conductive plating layer inside and outside the through hole is reduced, a subconformal phenomenon is avoided, uniformity of the conductive plating layer inside and outside the through hole is improved, and performance of the conductive plating layer and even the chip is improved. In addition, because the adhesive layer is a nickel-containing film layer, the seed layer may be manufactured on the surface of the adhesive layer, and gold is not deposited at another position without the adhesive layer. This resolves a problem of gold waste caused by deposition of most gold on an inner wall of a device cavity in a PVD method, and reduces amount of gold used, so that manufacturing costs of the chip are reduced.

Because a principle of resolving a problem by using the manufacturing method is similar to a principle of resolving a problem by using the chip described above, for an embodiment and a technical effect of the manufacturing method, refer to the embodiment and the technical effect of the chip described above. Details are not described again.

According to a third aspect, an embodiment of this application provides an electronic device. The electronic device may include a circuit board and the chip described in the first aspect. The chip is disposed on the circuit board. Improving uniformity of thicknesses of a conductive plating layer inside and outside a through hole can improve performance of the conductive plating layer and even the chip, can reduce manufacturing costs, and can improve manufacturing efficiency of the conductive plating layer, so that the electronic device manufactured by using the chip can also achieve objectives of improving performance, reducing manufacturing costs, and improving manufacturing efficiency.

Because a principle of resolving a problem by using the electronic device is similar to a principle of resolving a problem by using the chip described above, for an embodiment and a technical effect of the electronic device, refer to the embodiment and the technical effect of the chip described above. Details are not described again.

### BRIEF DESCRIPTION OF DRAWINGS

FIG. 1 is a diagram of a structure of an electronic device according to an embodiment of this application;
FIG. 2 is a diagram of a structure of a chip according to an embodiment of this application;
FIG. 3 is a diagram of a manufacturing process of a chip according to an embodiment of this application;
FIG. 4 is a cross-sectional view of an adhesive layer and a chemical gold-plated layer according to an embodiment of this application;
FIG. 5 is a cross-sectional view of an adhesive layer and a gold layer in the conventional technology;
FIG. 6 is a cross-sectional view of a gold electroplated layer manufactured on a chemical gold-plated layer; and
FIG. 7 is a cross-sectional view of a gold electroplated layer manufactured on a gold layer manufactured by using a PVD method.

### Reference numerals:

10: substrate; 11: through hole; 20: conductive structure; 30: conductive plating layer; 31: adhesive layer; 32: chemical gold-plated layer; 33: gold electroplated layer; 100: housing; 200: circuit board; 300: chip; b1: first surface; b2: second surface; and b3: hole wall.

### DESCRIPTION OF EMBODIMENTS

To make the objectives, technical solutions, and advantages of this application clearer, the following further describes this application in detail with reference to the accompanying drawings.

It should be noted that same reference numerals in the accompanying drawings of this application denote same or similar structures. Therefore, repeated descriptions thereof are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

For ease of understanding the technical solutions provided in embodiments of this application, the following first describes application scenarios.

A chip provided in embodiments of this application may be widely used in various electronic devices. The electronic device may include various terminal devices and electronic components. The terminal device may include but is not limited to devices such as a smartphone, a smart television, a smart television set-top box, a smartwatch, a personal computer (personal computer, PC), a wearable device, and an intelligent broadband device. The electronic component may include but is not limited to a telecommunication device like a wireless network, a fixed network, and a server, and a component like a chip module or a memory. Details are not described herein.

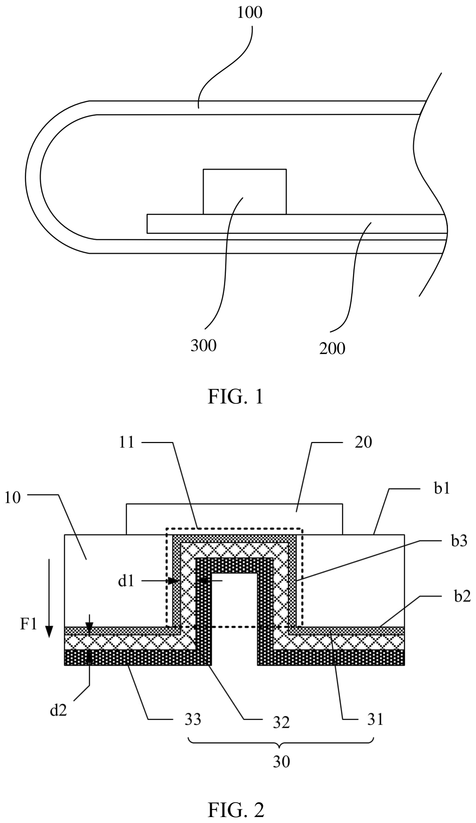

FIG. 1 is a diagram of a structure when a chip is applied to an electronic device. As shown in FIG. 1, the electronic device includes a housing 100 and a circuit board 200 disposed in the housing 100. The chip 300 is disposed on the circuit board 200. The chip 300 may include a substrate and a semiconductor device disposed on the substrate. The semiconductor device is, for example, a transistor or a capacitor. In the substrate, one side of surface on which the semiconductor device is disposed may be referred to as a front surface of the substrate, and the other side of surface may be referred to as a back surface of the substrate. When a through hole is provided in the substrate, the through hole may be covered by a power supply end or a ground end of the semiconductor device. Therefore, when a conductive plating layer is manufactured on the back surface of the substrate, the conductive plating layer covers not only the back surface of the substrate, but also a side wall of the through hole and a surface that is of the power supply end or the ground end and that is exposed from the through hole, so that the conductive plating layer is connected to the power supply end or the ground end. In this way, heat generated when the semiconductor device works can be conducted out from the back surface of the substrate, so that a heat dissipation capability of the chip 300 is improved. In addition, structural complexity of the front surface of the substrate can be reduced, and a power line or a ground line required in a circuit is simplified by using space on the back surface of the substrate.

Currently, when the conductive plating layer is manufactured on the back surface of the substrate, a titanium layer or a titanium-tungsten layer may be first sputtered on the back surface of the substrate, the side wall of the through hole, and the surface that is of the power supply end or the ground end and that is exposed from the through hole by using a PVD method as an adhesive layer, then, a layer of gold is sputtered on a surface of the adhesive layer by using the PVD method as a seed layer, and finally, gold is plated on a surface of the seed layer by using an electroplating method to increase a thickness of the conductive plating layer. Because the PVD method cannot be used to control an incident angle of a particle, it is difficult for a particle with a large angle to enter the through hole. Consequently, a thickness of the seed layer outside the through hole is large, and a thickness of the seed layer inside the through hole is small. Based on a principle that a greater thickness indicates a smaller resistance and a smaller thickness indicates a greater resistance, during gold plating, a thickness of gold inside the through hole is far less than a thickness of gold outside the through hole. This leads to a large difference between thicknesses of the conductive plating layer inside and outside the through hole, and finally leads to poor performance of the conductive plating layer.

In view of this, embodiments of this application provide a chip, a manufacturing method thereof, and an electronic device, to reduce a difference between thicknesses of a conductive plating layer inside and outside a through hole, avoid a subconformal phenomenon, improve uniformity of the conductive plating layer inside and outside the through hole, and improve performance of the conductive plating layer and even the chip.

FIG. 2 is a diagram of a structure of a chip according to an embodiment of this application. As shown in FIG. 2, the chip may include a substrate 10 and a conductive structure 20. The substrate 10 has a first surface b1 and a second surface b2 that are disposed opposite to each other, and a through hole 11 that penetrates the first surface b1 and the second surface b2. There may be one, two, three, or more through holes 11, with no quantity limitation herein, since how many through holes are provided. The conductive structure 20 may be disposed on the first surface b1. One, two, or more conductive structures 20 may be disposed. Functions of the conductive structures 20 include but are not limited to transmitting a power signal, a ground signal, or another signal. The functions of the conductive structures 20 may be the same, partially the same, or all different, and may be specifically set based on an actual requirement. Regardless of a quantity of disposed conductive structures 20 and setting of a function of each conductive structure 20, the requirement is met provided that one conductive structure 20 covers the through hole 11. In addition, a quantity of through holes 11 covered by the conductive structure 20 is not limited herein either.

Still refer to FIG. 2. The chip may further include a conductive plating layer 30. The conductive plating layer 30 may be formed on the second surface b2, a side wall of the through hole 11, and a surface that is of the conductive structure 20 and that is exposed from the through hole 11. A part of the second surface b2 other than the through hole 11 may be referred to as an area other than the through hole. The side wall of the through hole 11 may be referred to as a hole wall b3 for short. The surface that is of the conductive structure 20 and that is exposed from the through hole 11 may be considered as a hole bottom. In this way, the conductive plating layer 30 is disposed on the area other than the through hole, the hole wall b3, and the hole bottom, and the conductive plating layer 30 is connected to the conductive structure 20, so that heat in the conductive structure 20 may be conducted out to the second surface b2 through the conductive plating layer 30 and dissipated through the second surface b2, and a signal transmitted by the conductive structure 20 may be transmitted to the conductive plating layer 30.

The conductive plating layer 30 may include an adhesive layer 31 that is formed on the area other than the through hole, the hole wall b3, and the hole bottom, a chemical gold-plated layer 32 formed on the adhesive layer 31, and a gold electroplated layer 33 formed on the chemical gold-plated layer 32, so that the adhesive layer 31, the chemical gold-plated layer 32, and the gold electroplated layer 33 are sequentially stacked in a direction (namely, a direction F1 in FIG. 2) from the first surface b1 to the second surface b2. A manufacturing material of the adhesive layer 31 includes a nickel element. For example, the adhesive layer 31 may be made of at least one of elemental nickel and a nickel-containing inorganic compound. The nickel-containing inorganic compound may be selected from, but not limited to, at least one of a nickel-vanadium alloy, a nickel phosphide, a nickel nitride, a nickel boride, a nickel-tungsten alloy, a nickel-aluminum alloy, a nickel-titanium alloy, a nickel-thallium alloy, a nickel-chromium alloy, and the like, so that a material selection range is wide, and requirements in various application scenarios are met. In addition, the adhesive layer 31 may be of a single-layer structure or a multi-layer structure. When the adhesive layer 31 is of a multi-layer structure, materials of layers may be the same or different, and may be specifically set based on an actual requirement.

In this way, when the chemical gold-plated layer (which may also be referred to as a seed layer) 32 is manufactured on the nickel-containing adhesive layer 31 by using a chemical gold plating method, because chemical plating is not affected by an electric field or a magnetic field, there is no problem related to an incident angle of a particle, and gold can easily enter the through hole 11 without being affected by the incident angle. Gold is deposited on a surface of the adhesive layer 31 through a replacement reaction between nickel and gold, and gold entering the through hole 11 can increase a thickness of the seed layer inside the through hole 11, to reduce a difference between thicknesses of the seed layer inside and outside the through hole 11, so that a difference between thicknesses of the gold electroplated layer 33 inside and outside the through hole 11 is reduced. In this way, a difference between thicknesses of the conductive plating layer 30 inside and outside the through hole 11 is reduced, a subconformal phenomenon is avoided, uniformity of the conductive plating layer 30 inside and outside the through hole 11 is improved, and performance of the conductive plating layer 30 and even the chip is improved.

For example, the adhesive layer 31 may be formed by using a PVD method, so that the adhesive layer 31 that is manufactured may be a nickel-containing film layer. In this way, through a replacement reaction between nickel and gold, a gold layer may be manufactured on a surface of the adhesive layer 31 by using a chemical gold plating method, to obtain the seed layer, and gold is not deposited at another position without the adhesive layer 31. This resolves a problem of gold waste caused by deposition of most gold on an inner wall of a device cavity in the PVD method, and reduces amount of gold used, so that manufacturing costs of the chip are reduced.

It should be understood that the chemical gold plating method is a method of depositing gold on the adhesive layer 31 through a chemical reaction based on a redox principle, and this method does not require externally supplying a current. The gold electroplating method is a method of forming a gold layer by discharging gold ions under an action of an externally supplied current.

As shown in FIG. 2, for the chemical gold-plated layer 32, if a ratio of a first thickness d1 at any position inside the through hole 11 to a second thickness d2 at any position on the second surface b2 is set to be greater than or equal to 0.5, it indicates that a difference between thicknesses of the seed layer inside and outside the through hole 11 is small, and resistance of the seed layer inside the through hole 11 is effectively reduced. Therefore, when the gold electroplated layer 33 is manufactured on the seed layer by using a gold electroplating method, the gold electroplated layer 33 inside the through hole 11 may be thick to further reduce the difference between thicknesses inside and outside the through hole 11 during gold electroplating, further improve thickness uniformity of the conductive plating layer 30, and further reduce gold electroplating time. This can not only reduce amount of gold used, but also improve manufacturing efficiency of the conductive plating layer 30 and even the chip.

As shown in FIG. 2, for the chemical gold-plated layer 32, setting the second thickness d2 at any position on the second surface b2 to be greater than or equal to 300 nm helps implement a specific thickness of the chemical gold-plated layer 32 inside the through hole 11, and avoids an excessively large resistance caused by an excessively thin chemical gold-plated layer 32 inside the through hole 11. This helps reduce the difference between thicknesses of the gold electroplated layer 33 inside and outside the through hole 11, reduce the difference between thicknesses of the conductive plating layer 30 inside and outside the through hole 11, and further reduce the difference between thicknesses of the conductive plating layer 30 inside and outside the through hole 11 especially when the ratio of the first thickness d1 to the second thickness d2 is greater than or equal to 0.5.

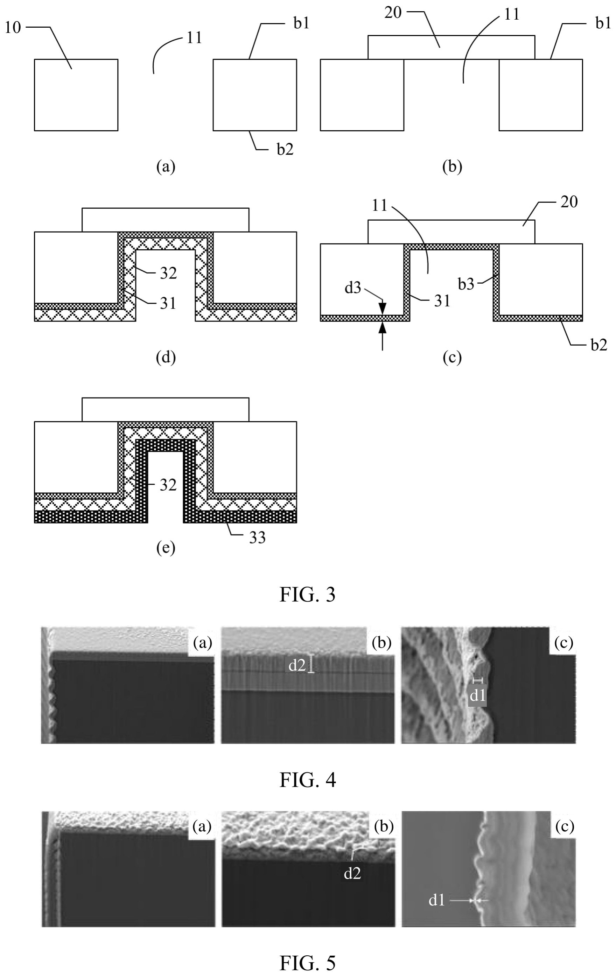

FIG. 3 shows an example of a schematic flowchart of a chip manufacturing method according to an embodiment of this application. As shown in FIG. 3, the method may include the following steps.

Step 1: As shown in (a) in FIG. 3, form a through hole 11 penetrating a first surface b1 and a second surface b2 in a substrate 10 having the first surface b1 and the second surface b2 that are disposed opposite to each other.

As shown in (a) in FIG. 3, the first surface b1 and the second surface b2 in the substrate 10 are disposed opposite to each other in a thickness direction of the substrate 10, and the through hole 11 extends in the thickness direction of the substrate 10 and penetrates the first surface b1 and the second surface b2. A size and a shape of the through hole 11 may be set based on an actual requirement. For example, but not limited to, a cross section that is of the through hole 11 and that is parallel to the first surface b1 may in an elliptical shape, a circular shape, or an irregular shape. Taking the elliptical shape as an example, the shortest diameter may be but is not limited to 30 µm, and the longest diameter may be but is not limited to 60 µm. In addition, when the through hole 11 is manufactured, the through hole 11 may be etched in the substrate 10 through, but not limited to, plasma etching.

Step 2: As shown in (b) in FIG. 3, form, on the first surface b1, a conductive structure 20 that covers the through hole 11.

As shown in (b) in FIG. 3, this figure is shown by using an example in which one conductive structure 20 covers one through hole 11. If the structure in (b) in FIG. 3 is reversed, a surface that is of the conductive structure 20 and that is exposed from the through hole 11 may be considered as a hole bottom of the through hole 11.

Step 3: Form a conductive plating layer 30 on the second surface b2, a side wall of the through hole 11, and a surface that is of the conductive structure 20 and that is exposed from the through hole 11. The conductive plating layer 30 includes an adhesive layer 31, a chemical gold-plated layer 32, and a gold electroplated layer 33 that are sequentially stacked in a direction from the first surface b1 to the second surface b2. The adhesive layer 31 includes a nickel element.

The following describes in detail a process of manufacturing the conductive plating layer 30. The process may specifically include the following steps.

Step 3.1: As shown in (c) in FIG. 3, based on a PVD method, a material including the nickel element is used to form the adhesive layer 31 on the second surface b2, a hole wall b3, and the hole bottom. A thickness d3 of the adhesive layer 31 may be controlled to be from 0.1 µm to 0.5 µm.

Step 3.2: Clean a chip on which the adhesive layer 31 is formed.

For example, plasma with a specific power (for example, but not limited to 400 W) is used, an inert gas (for example, but not limited to argon) is introduced to clean the chip on which the adhesive layer 31 is formed for a period of time (for example, but not limited to 90s), and then the cleaned chip is kept in a vacuum for a period of time (for example, but not limited to 5 min), to remove an organic contaminant on a surface of the chip. Then, the chip is cleaned by using a sulfuric acid solution with specific concentration (for example, but not limited to 5%) at a room temperature, to remove an oxide film on the surface of the chip.

Step 3.3: As shown in (d) in FIG. 3, the chemical gold-plated layer 32 is formed on the adhesive layer 31 by using a chemical gold plating method.

A specific manufacturing process of the chemical gold-plated layer 32 may include the following two steps: In a first step, a replacement gold plating solution is used to perform a replacement reaction between nickel and gold on a surface of the adhesive layer 31, so that the surface of the adhesive layer 31 includes gold (which may be referred to as a replaced gold layer). In a second step, a chemical gold plating solution is used to continue gold plating on the surface of the replaced gold layer, to increase a thickness of the gold layer, so as to obtain the chemical gold-plated layer 32. In this way, a thickness of the chemical gold-plated layer 32 at any position on the second surface b2 is greater than or equal to 300 nm, and a ratio of a thickness of the chemical gold-plated layer 32 at a middle position of the through hole 11 to the thickness of the chemical gold-plated layer 32 at any position on the second surface b2 is greater than or equal to 0.5.

For example, the replacement gold plating solution usually includes a plurality of components. The components of a specific volume are measured and mixed together, and are supplemented until a target volume (for example, but not limited to 1 L), so as to obtain a mixed solution A. A pH value of the mixed solution A is adjusted to a preset value (for example, but not limited to 7.2), and a temperature of the mixed solution A is increased to a preset temperature (for example, but not limited to 74°C). Then, the chip processed in step 3.2 is put in the heated mixed solution A, so that a replacement reaction occurs between nickel and gold on the surface of the adhesive layer 31. After the reaction lasts for a period of time (for example, but not limited to 12 min), the chip is taken out and cleaned, to obtain the chip on which the replaced gold layer is included on the surface of the adhesive layer 31.

For example, the chemical gold plating solution also generally includes a plurality of components. Components of a specific volume are measured and mixed together, and supplemented until a target volume (for example, but not limited to 1 L), so to obtain a mixed solution B. A pH value of the mixed solution B is adjusted to a preset value (for example, but not limited to 7.2), and a temperature of the mixed solution B is increased to a preset temperature (for example, but not limited to 50°C). Then, the chip on which the replaced gold layer is formed is put in the heated mixed solution B, so that a reduction reaction occurs on gold in the chemical gold plating solution, and a reduced gold layer is formed on a surface of the replaced gold layer to increase a thickness of the gold layer. After the reaction lasts for a period of time (for example, but not limited to 3 minutes), the chip is taken out and cleaned, to obtain the chip on which the chemical gold-plated layer 32 is formed. The chemical gold-plated layer 32 includes the replaced gold layer and the reduced gold layer.

Certainly, manufacturing the chemical gold-plated layer 32 is not limited to the foregoing two-step method, and may alternatively use another method that can be used to obtain the chemical gold-plated layer 32. This is not limited herein.

Step 3.4: Clean the chip on which the chemical gold-plated layer 32 is formed.

Specifically, for a specific cleaning process, refer to the cleaning process described in step 3.2.

Step 3.5: As shown in (e) in FIG. 3, form the gold electroplated layer 33 on the chemical gold-plated layer 32.

When the gold electroplated layer 33 is formed, the chip processed in step 3.4 may be first fastened to a substrate with the chemical gold-plated layer 32 facing upward, and then the substrate fastened with the chip is transferred to a fixture of an electroplating machine to perform step-by-step electroplating by using the electroplating gold solution. After the electroplating is completed, the chip is cleaned by using deionized water and dried to obtain the gold electroplated layer 33.

For example, currents used in electroplating steps during step-by-step electroplating may be different, and magnitudes of currents used in the electroplating steps may be sequentially increased based on an electroplating sequence. For example, two-step electroplating is used as an example. A current used in a first step of electroplating is less than a current used in a second step of electroplating. An advantage of such a setting is that a smaller current is used in a previous electroplating step, so that a thickness of gold inside the through hole 11 can be increased, to reduce a difference between thicknesses of gold inside and outside the through hole 11. A greater current is used in a subsequent step, so that a thickness of gold can be increased to reach a designed thickness of the gold electroplated layer 33. In this way, a small difference between thicknesses of the gold electroplated layer 33 inside and outside the through hole 11 can be ensured, and manufacturing efficiency can be further improved. Certainly, step-by-step electroplating may be but is not limited to two-step electroplating, and may be specifically determined based on an actual situation, which is not limited herein.

The following describes the conductive plating layer by using specific test results.

Embodiment: as shown in FIG. 4 and FIG. 5, FIG. 4 is a cross-sectional view of an adhesive layer and a chemical gold-plated layer at different positions and different magnifications according to an embodiment of this application, and FIG. 5 is a cross-sectional view of an adhesive layer and a gold layer at different positions and different magnifications in the conventional technology. The adhesive layer in the conventional technology is manufactured by using a PVD method, and a material used for manufacturing the adhesive layer is titanium. The gold layer in the conventional technology is manufactured by using the PVD method. In addition, in FIG. 4 and FIG. 5, a magnification of (a) is greater than a magnification of (b), and a magnification of (b) is greater than a magnification of (c). By comparing structures shown in FIG. 4 and FIG. 5, it is found that:
1. A second thickness d2 of the chemical gold-plated layer provided in this embodiment of this application on a second surface is about 592 nm to 620 nm. As shown in (b) in FIG. 4, a first thickness d1 of the chemical gold-plated layer corresponding to a half depth of a through hole is about 324 nm to 374 nm. As shown in (c) in FIG. 4, a ratio of the first thickness d1 to the second thickness d2 is greater than 0.5. Therefore, the chemical gold-plated layer provided in this embodiment of this application has a large thickness and a flat surface (as shown in (a) in FIG. 4).
2. A second thickness d2 of the gold layer in the conventional technology on a second surface is about 128 nm to 256 nm. As shown in (b) in FIG. 5, a first thickness d1 of the gold layer corresponding to a half depth of a through hole is about 31 nm to 40 nm. As shown in (c) in FIG. 5, the ratio of the first thickness d1 to the second thickness d2 is less than 0.3. Therefore, the gold layer in the conventional technology is thin, is in an island shape, and has an uneven surface (as shown in (a) in FIG. 5).

It is found through analysis that: Through comparison between the chemical gold-plated layer and the gold layer manufactured by using the PVD method, the gold layer deposited by using the PVD method has large internal stress. Increasing a thickness of the gold layer may lead to warpage of the gold layer and separation from the adhesive layer, and even tearing of wafer. Therefore, the obtained gold layer is in an island shape and has an uneven surface. In addition, most of gold is deposited on an inner wall of a device cavity in the PVD method, and therefore, gold deposited on the adhesive layer is limited. Consequently, the gold layer is thin. However, the gold layer (namely, the chemical gold-plated layer) manufactured by using the chemical plating method can avoid the foregoing problem, so that the manufactured chemical gold-plated layer has a flat surface and a large thickness.

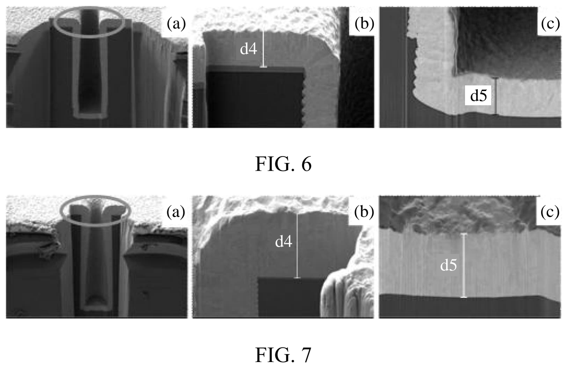

Embodiment: as shown in FIG. 6 and FIG. 7, FIG. 6 is a cross-sectional view of a gold electroplated layer manufactured on a chemical gold-plated layer at different positions and at different magnifications, and FIG. 7 is a cross-sectional view of a gold electroplated layer manufactured on a gold layer manufactured by using a PVD method at different positions and at different magnifications. In FIG. 6 and FIG. 7, a magnification of (a) is greater than a magnification of (b), and a magnification of (b) is greater than a magnification of (c). By comparing structures shown in FIG. 6 and FIG. 7, it is found that:
1. A thickness of the gold electroplated layer manufactured on the gold layer manufactured by using the PVD method is large in an area rather than a through hole and small at a hole bottom, and a subconformal phenomenon occurs, as shown in a solid circle in (a) in FIG. 7. When the gold layer is manufactured by using the PVD method, due to a problem related to an incident angle of a particle, it is difficult to effectively sputter gold into the through hole, and consequently, the gold layer inside the through hole has a small thickness and a large resistance. Therefore, in an electroplating process, a current inside the through hole is small, and a thickness of the gold electroplated layer is small, especially at the hole bottom. A difference between thicknesses of the chemical gold-plated layer inside and outside the through hole is small, and a resistance of the chemical gold-plated layer inside the through hole is small. In this case, the current inside the through hole in the electroplating process is large, the thickness of the gold electroplated layer inside the through hole is increased, and a subconformal phenomenon is avoided, as shown in a solid circle in (a) in FIG. 6.
2. For the gold electroplated layer manufactured on the gold layer manufactured by using the PVD method, a thickness d4 of the gold electroplated layer in the area other than the through hole is about 8.51 µm, as shown in (b) in FIG. 7, a thickness d5 of the gold electroplated layer at the hole bottom is about 3.90 µm, as shown in (c) in FIG. 7, and a ratio of the thickness d5 to the thickness d4 is 45.9%. For the gold electroplated layer manufactured on the chemical gold-plated layer, a thickness d4 of the gold electroplated layer in the area other than the through hole is about 7.63 µm, as shown in (b) in FIG. 6, a thickness d5 of the gold electroplated layer at the hole bottom is about 4.64 µm, as shown in (c) in FIG. 6, and a ratio of the thickness d4 to the thickness d5 is 60.8%. It can be learned that a smaller difference between thicknesses of the gold electroplated layer that is inside and outside the through hole and that is manufactured on the chemical gold-plated layer indicates a greater thickness of the gold electroplated layer inside the through hole. If the thickness of the gold electroplated layer at the hole bottom is required to be 4 µm, based on the above ratio, when the gold electroplated layer is manufactured on the gold layer manufactured by using the PVD method, the gold electroplated layer in the area other than the through hole needs to be electroplated to 8.87 µm. When the gold electroplated layer is manufactured on the chemical gold-plated layer, the gold electroplated layer in the area other than the through hole only needs to be electroplated to 6.58 µm. Through comparison, manufacturing the gold electroplated layer on the chemical gold-plated layer can save 30% of electroplating gold, so that an amount of gold used can be effectively reduced, and manufacturing costs are reduced. From another perspective, manufacturing the gold electroplated layer on the chemical gold-plated layer achieves a good filling capability for the through hole.

It should be understood that, during gold electroplating, the gold in the through hole is consumed relatively and cannot be replenished in time. Therefore, thicknesses of the gold electroplated layer inside and outside the through hole in the two processes cannot be equal.

Clearly, persons skilled in the art can make various modifications and variations to embodiments of this application without departing from the spirit and scope of embodiments of this application. In this case, this application is intended to cover these modifications and variations of the embodiments of this application provided that they fall within the scope of protection defined by the following claims and their equivalent technologies.

## Claims

1. A chip, comprising:
a substrate, wherein the substrate has a first surface and a second surface that are disposed opposite to each other, and a through hole that penetrates the first surface and the second surface;
a conductive structure, wherein the conductive structure is located on the first surface and covers the through hole; and
a conductive plating layer, wherein the conductive plating layer is formed on the second surface, a side wall of the through hole, and a surface that is of the conductive structure and that is exposed from the through hole, the conductive plating layer comprises an adhesive layer, a chemical gold-plated layer, and a gold electroplated layer that are sequentially stacked in a direction from the first surface to the second surface, and the adhesive layer comprises a nickel element.

2. The chip according to claim 1, wherein the chemical gold-plated layer at any position inside the through hole has a first thickness, the chemical gold-plated layer at any position on the second surface has a second thickness, and a ratio of the first thickness to the second thickness is greater than or equal to 0.5.

3. The chip according to claim 2, wherein any position inside the through hole comprises a position at a half depth of the through hole.

4. The chip according to any one of claims 1 to 3, wherein a thickness of the chemical gold-plated layer at any position on the second surface is greater than or equal to 300 nm.

5. The chip according to any one of claims 1 to 4, wherein an atomic percent of the nickel element comprised in the adhesive layer is greater than or equal to 80%.

6. The chip according to any one of claims 1 to 5, wherein the adhesive layer comprises at least one of elemental nickel and a nickel-containing inorganic compound.

7. The chip according to any one of claims 1 to 6, wherein a thickness of the adhesive layer ranges from 0.1 µm to 0.5 µm.

8. A chip manufacturing method, comprising:
forming a conductive structure on a substrate, wherein the substrate has a first surface and a second surface that are disposed opposite to each other, and a through hole that penetrates the first surface and the second surface, and the conductive structure is located on the first surface and covers the through hole;
forming an adhesive layer on the second surface, a side wall of the through hole, and a surface that is of the conductive structure and that is exposed from the through hole, wherein the adhesive layer comprises a nickel element;
forming a chemical gold-plated layer on the adhesive layer; and
forming a gold electroplated layer on the chemical gold-plated layer.

9. The manufacturing method according to claim 8, wherein forming the adhesive layer comprises:
forming the adhesive layer by using a physical vapor deposition method.

10. The manufacturing method according to claim 8 or 9, wherein the chemical gold-plated layer formed at any position inside the through hole has a first thickness, the chemical gold-plated layer formed at any position on the second surface has a second thickness, and a ratio of the first thickness to the second thickness is greater than or equal to 0.5.

11. The manufacturing method according to any one of claims 8 to 10, wherein a thickness of the chemical gold-plated layer formed at any position on the second surface is greater than or equal to 300 nm.

12. An electronic device, comprising a circuit board and the chip according to any one of claims 1 to 7, wherein the chip is disposed on the circuit board.
